# EUROPÄISCHE PATENTANMELDUNG

(11) **EP 2 980 804 A1**
(43) Veröffentlichungstag der Anmeldung: **03.02.2016**
(21) Anmeldenummer: 14179212.7
(22) Anmeldetag: 31.07.2014
(51) Int. Cl.: H01B 12/06, H01L 39/24, H01L 39/14

(54) **Vorprodukt sowie Verfahren zur Herstellung eines bandförmigen Hochtemperatursupraleiters**

(71) Anmelder: BASF SE, 67056 Ludwigshafen (DE)
(72) Erfinder: Wojtyniak, Brygida, 53340 Meckenheim (DE); Weimann, Viktor, 53340 Meckenheim (DE); Bäcker, Michael, 50670 Köln (DE); Falter, Martina, 53913 Swisttal-Buschhoven (DE)
(74) Vertreter: Eisenführ Speiser

(57) **Zusammenfassung**

Die vorliegende Erfindung betrifft ein Vorprodukt (1) zur Herstellung eines bandförmigen Hochtemperatursupraleiters (HTS), umfassend ein metallisches bandförmiges Substrat (10) mit einer ersten Bandseite (11) und einer zweiten Bandseite (12), wobei auf der ersten Bandseite (11) (a) das Substrat (10) eine vorgegebene Textur als Templat für ein kristallografisch ausgerichtetes Aufwachsen einer Pufferschicht oder einer HTS-Schicht besitzt und (b) eine freiliegende Oberfläche des Substrats (10) vorliegt oder eine oder mehrere Schichten (20,30) vorliegen, die ausgewählt sind aus der Gruppe bestehend aus: Puffer-Precursor-Schicht, pyrolysierte Puffer-Precursor-Schicht, Pufferschicht, HTS-Precursor-Schicht, pyrolysierte HTS-Puffer-Precursor-Schicht und pyrolysierte und weiter verdichtete HTS-Puffer-Precursor-Schicht, und auf der zweiten Bandseite (12) mindestens eine das Substrat (10) gegen Oxidation schützende keramische Barriereschicht (40) oder eine Vorstufe, die sich während der HTS-Kristallisationsglühung oder der Pyrolyse in eine solche umwandelt, vorliegt, wobei, wenn auf der ersten Bandseite (11) eine oder mehrere Schichten (20, 30) vorliegen, die keramische Barriereschicht (40) oder deren Vorstufe eine andere chemische Zusammensetzung besitzt und/oder eine andere Textur besitzt als die auf der ersten Bandseite (11) angeordnete Schicht (20), welche unmittelbar an dem Substrat (10) anliegt.

## Beschreibung

### Technisches Gebiet

Die Erfindung betrifft ein Vorprodukt sowie ein Verfahren zur Herstellung eines bandförmigen Hochtemperatursupraleiters (HTS) und einen mit einem solchen Verfahren erhältlichen bandförmigen HTS.

### Stand der Technik

Bandförmige Hochtemperatursupraleiter, auch als Coated Conductors bezeichnet, umfassen ein (üblicherweise aus Metallen einschließlich Edelmetallen, Metalllegierungen oder Metallverbundwerkstoffen bestehendes, im folgenden als "metallisch" bezeichnetes) bandförmiges Trägersubstrat, auf das, ggf. nach vorherigem Aufbringen einer oder mehrerer Zwischen- oder Pufferschichten, mindestens eine supraleitende Funktionsschicht aufgebracht wird.

Ein wesentlicher Punkt bei der Herstellung von Coated Conductors ist das Erfordernis, dass die supraleitende Schicht eine extrem hohe Textur, d. h. kristallographische Orientierung, aufweisen muss. Die einzelnen Kristallite der supraleitenden Schicht dürfen dabei nur geringfügig gegeneinander verkippt sein, um die supraleitenden Eigenschaften über makroskopische Längen nicht zu beeinträchtigen (High Temperature Superconductivity 1: Materials, A.V. Narlikar (Hrg.) Springer-Verlag, 2004, 115-167).

Um einen solchen hohen Texturgrad zu erreichen, werden zwei unterschiedliche Herstellungsansätze verfolgt. Bei beiden Ansätzen werden Metallsubstrate verwendet, weil nur so die für die spätere Verwendung erforderliche Festigkeit und gleichzeitig eine Biegsamkeit der Endprodukte erreicht werden kann. Darüber hinaus wird bei beiden Absätzen vor dem Abscheiden der supraleitenden Schicht mindestens eine texturierte Zwischen- oder Pufferschicht erzeugt, die ihre Textur an die supraleitende Schicht bei deren Abscheidung überträgt.

Beim ersten Ansatz wird von hinsichtlich ihrer kristallografischen Orientierung noch nicht besonders geeigneten Metallsubstraten ausgegangen, auf die anschließend die Pufferschicht mit der gewünschten Orientierung aufgebracht wird. Eine solche gerichtete Abscheidung kann nur mittels physikalischer Beschichtungsverfahren, z. B. Ion Beam Assisted Deposition (IBAD) und Inclined Substrate Deposition (ISD), im Hochvakuum erfolgen. Diese Verfahren sind mit einem hohen apparativen Aufwand verbunden.

Beim zweiten Ansatz wird das Metallsubstrat bereits durch spezielle Verfahren texturiert (s. z. B. DE 101 43 680 C1, CN 1 117 879 C, DE 100 05 861 A1). Diese Textur des Metallsubstrats wird dann in den nachfolgenden Schritten zunächst auf die Pufferschicht und von dort auf die supraleitende Schicht übertragen. Da für das Aufbringen der weiteren Schichten keine gerichteten Abscheideverfahren verwendet werden müssen, können hier sowohl physikalische Verfahren als auch insbesondere chemische Verfahren, wie Chemical Solution Deposition (CSD), eingesetzt werden.

Besonders wirtschaftlich, sowohl im Hinblick auf Anlagen, als auch Betriebskosten, sind chemische Verfahren, wie das CSD-Verfahren, da diese üblicherweise bei Normaldruck arbeiten und eine hohe Abscheiderate ermöglichen. Im Mittelpunkt gegenwärtiger Entwicklungsarbeiten stehen daher Herstellungsprozesse für Coated Conductors, bei denen auf ein texturiertes Metallsubstrat über chemische Abscheidung zunächst eine oder mehrere Pufferschichten und anschließend die supraleitende Schicht aufgebracht werden. Durch abschließende Kristallisation jeder zuvor aufgebrachten und pyrolysierten Schicht wird dann erreicht, dass die Textur der jeweils direkt darunter liegenden bereits texturierten Schicht bzw. des Metallsubstrats übertragen wird.

Die Funktion der Pufferschicht bzw. der Pufferschichten besteht zum einen darin, die Korrosion des Metallsubstrates durch Oxidation zu verhindern, wodurch die Orientierung zumindest an der Metalloberfläche verloren ginge; zum anderen muss die Diffusion von Metallionen wie Nickel oder Eisen in die supraleitende Schicht verhindert werden, um deren Qualität nicht zu beeinträchtigen. Im schlimmsten Fall würden die supraleitenden Eigenschaften des Materials verloren gehen.

Bei der abschließenden HTS-Kristallisationsglühung eines HTS-Vorprodukts zur Kristallisation der abschließend aufgebrachten HTS-Precursor-Schicht (oder auch schon bei der Pyrolyse der HTS-Precursor-Schicht oder einer Pufferschicht) kann es allerdings durch die dabei zum Einsatz kommenden hohen Temperaturen und die sauerstoffhaltige sowie teilweise feuchte Atmosphäre bei der thermischen Behandlung zu Schäden an dem texturierten Metallsubstrat, insbesondere durch oxidative Prozesse, kommen. Dies ist an der Vorderseite (der ersten Bandseite) nicht zwingend schädlich, solange dort bereits fest haftende Pufferschicht(en) (insbesondere nicht-leitende Pufferschichten) schon angebracht wurden und zudem eine elektrische Ankopplung über die Rückseite noch stattfinden kann.

### Aufgabe der Erfindung

Der Erfindung liegt daher die Aufgabe zugrunde, ein HTS-Vorprodukt, insbesondere die Bandrückseite (zweite Bandseite), vor einer Schädigung durch oxidative Prozesse während der HTS-Kristallisationsglühung bzw. schon während der Pyrolyse zu schützen.

### Gegenstand der Erfindung

Erfindungsgemäß wird diese Aufgabe gelöst durch ein Vorprodukt zur Herstellung eines bandförmigen Hochtemperatursupraleiters (HTS), umfassend
ein metallisches bandförmiges Substrat mit einer ersten Bandseite und einer zweiten Bandseite, wobei
auf der ersten Bandseite
(a) das Substrat eine vorgegebene Textur als Templat für ein kristallografisch ausgerichtetes Aufwachsen einer Pufferschicht oder einer HTS-Schicht besitzt
   und
(b) eine freiliegende Oberfläche des Substrats vorliegt oder eine oder mehrere Schichten vorliegen, die ausgewählt sind aus der Gruppe bestehend aus: Puffer-Precursor-Schicht, pyrolysierte Puffer-Precursor-Schicht, Pufferschicht, HTS-Precursor-Schicht, pyrolysierte HTS-Puffer-Precursor-Schicht und pyrolysierte und weiter verdichtete HTS-Puffer-Precursor-Schicht,
   und
   auf der zweiten Bandseite mindestens eine das Substrat gegen Oxidation schützende keramische Barriereschicht oder eine Vorstufe, die sich während der HTS-Kristallisationsglühung oder der Pyrolyse in eine solche umwandelt, vorliegt,
   wobei, wenn auf der ersten Bandseite eine oder mehrere Schichten vorliegen, die Barriereschicht oder deren Vorstufe eine andere chemische Zusammensetzung besitzt und/oder eine andere Textur besitzt als die auf der ersten Bandseite angeordnete Schicht, welche unmittelbar an dem Substrat anliegt.

Durch die erfindungsgemäß vorgesehene Maßnahme der Anbringung mindestens einer keramischen Barriereschicht oder einer Vorstufe davon auf der metallischen Unterseite des HTS-Vorprodukts vor der Aufbringung oder Pyrolyse einer HTS-Precursor-Schicht (oder einer darunter angeordneten Pufferschicht) bzw. der abschließenden thermischen Behandlung zur HTS- oder Pufferschicht-Kristallisationsglühung kann das texturierte Metallsubstrat, z. B. eine Nickel-Wolfram-Legierung, und insbesondere dessen Unterseite, in überraschend einfacher und effektiver Weise vor oxidativen Prozessen geschützt werden.

Dabei kann die keramische Barriereschicht auf der Rückseite (=zweite Bandseite) des Metallsubstrats eines HTS-Vorprodukts während der Pyrolyse der HTS-Precursor-Schicht (oder einer darunter angeordneten Pufferschicht) bzw. der abschließenden HTS- oder Pufferschicht-Kristallisationsglühung nicht nur dem Schutz der Unterseite des Substrats vor Oxidation und damit dem Erhalt von dessen mechanischen und elektrischen Eigenschaften dienen, sondern sie erleichtert auch die Einstellung des gewünschten Sauerstoffpartialdrucks in der Glühatmosphäre, weil der ansonsten verweilzeitabhängige Sauerstoffkonsum des ungeschützten Metallsubstrats unterdrückt wird.

Bevorzugt ist vorgesehen, dass auf der ersten Bandseite eine einzelne Pufferschicht vorliegt und die Pufferschicht epitaktisch aufgewachsen ist oder mehrere epitaktisch aufgewachsene Pufferschichten vorliegen.

Dabei ist besonders bevorzugt vorgesehen, dass die keramische Barriereschicht oder deren Vorstufe eine andere chemische Zusammensetzung besitzt und/oder eine andere Textur besitzt als die auf der ersten Bandseite angeordnete einzelne Pufferschicht bzw. die unmittelbar an dem Substrat anliegende der mehreren Pufferschichten. Die keramische Barriereschicht ist bevorzugt eine den Sauerstoffzutritt zur zweiten Bandseite verzögernde oder verhindernde Schicht aus vorzugsweise leitfähigem oder nicht-leitfähigem keramischem Material (wobei das keramische Material vorzugsweise ein Metalloxid oder eine Mischung von Metalloxiden ist) oder es wird eine Vorstufe eingesetzt, die sich während der HTS-Kristallisationsglühung oder der Pyrolyse in eine solche Barriereschicht umwandelt,. Es ist bevorzugt vorgesehen, dass das keramische Material ein elektrisch leitfähiges Metalloxid oder eine elektrisch leitfähige Mischung von Metalloxiden ist, wobei das leitfähige Metalloxid bzw. ein oder mehrere Metalloxide der leitfähigen Mischung vorzugsweise ein mit einem Fremdmetall dotiertes Metalloxid sind. Das leitfähige mit einem Fremdmetall dotierte Metalloxid ist dabei vorzugsweise ausgewählt aus dotiertem Zinkoxid (vorzugsweise Al-dotiertem Zinkoxid), dotiertem Indiumoxid (vorzugsweise Sndotiertem Indiumoxid, z.B. 90% In203, 10% SnO2), mit Niob dotiertem Strontiumtitanat und dotiertem Lanthannickelat. Die Begriffe "leitfähig" und "Leitfähigkeit" beziehen sich in dieser Anmeldung stets auf elektrische Leitfähigkeit.

Eine leitfähige keramische Barriereschicht auf der zweiten Bandseite muss nach der HTS-Kristallisationsglühung vor dem Anbringen des Shunt nicht wieder entfernt werden, da die Leitfähigkeit an der zweiten Bandseite gegeben ist.

Der Dotierungsgrad des mit einem Fremdmetall dotierten Metalloxids liegt bevorzugt bei mindestens 1%, bezogen auf die Gesamtzahl der Metallionen in der Barriereschicht. Besonders bevorzugt ist vorgesehen, dass der Dotierungsgrad des mit einem Fremdmetall dotierten Metalloxids bei mindestens 5% liegt.

Bei Einsatz einer keramischen Barriereschicht aus nicht-leitfähigem Metalloxid ist diese Schicht aus nicht-leitfähigem Metalloxid vorzugsweise nach der HTS-Kristallisationsglühung leicht entfernbar. Einzelheiten zu diesem Aspekt sind weiter unten angegeben, unter Bezugnahme auf bevorzugte erfindungsgemäße Verfahren.Das Entfernen der Barriereschicht bzw. der Oxidschicht ist im Falle einer nicht ausreichend leitfähigen Ausführung dieser Barriereschicht bei gleichzeitiger Verwendung mindestens einer nicht selbst ausreichend leitfähigen Pufferschicht auf der HTS-Seite erforderlich, um die elektrische Leitfähigkeit senkrecht zum Schichtaufbau und damit die elektrische Anschlussfähigkeit des HTS wiederherzustellen.

Dabei ist besonders bevorzugt, dass die Dicke der Schicht aus nicht-leitfähigem Metall-oxid maximal 10% der Dicke des Substrats beträgt. Das nicht-leitfähige Metalloxid ist vorzugsweise ausgewählt aus der Gruppe bestehend aus Lanthanzirkonat (z. B. La₂Zr₂O₇), Yttriumoxid (z. B. Y₂O₃), Lanthanaluminat, (z. B. LaAlO₃), Strontiumtitanat (z. B. SrTiO₃) und Kalziumtitanat (z. B. CaTiO₃). Ein wichtiges Auswahlkriterium hierbei ist neben der Gasdichtigkeit die Kratzfestigkeit, um die Prozessierbarkeit in RTR-Öfen zu gewährleisten.

Die Erfindung betrifft außerdem ein Verfahren zur Herstellung eines bandförmigen HTS, mit folgendem Schritt:
- Bereitstellen oder Herstellen eines erfindungsgemäßen Vorprodukts (wie vorstehend beschrieben, vorzugsweise wie vorstehend als bevorzugt bezeichnet),
   wobei auf der ersten Bandseite eine pyrolysierte HTS-Precursor-Schicht vorliegt,
- Kristallisationsglühen des Vorprodukts.

In einem erfindungsgemäßen Verfahren wird die keramische Barriereschicht vorzugsweise mit einem CSD(Chemical Solution Deposition)-Verfahren auf das Metallsubstrat aufgebracht.

CSD-Verfahren sind aus den schon in der Beschreibungseinleitung genannten Gründen besonders wirtschaftlich.

Vorzugsweise ist das CSD-Verfahren dabei ausgewählt aus der Gruppe bestehend aus Tauchbeschichtung, Schlitzdüsenbeschichtung und Druckbeschichtung mit darauffolgender Wärmebehandlung.

CSD-Verfahren und insbesondere die Schlitzdüsenbeschichtung über einen Meniskus per Filz finden bevorzugt Anwendung beim Aufbringen von nicht-leitfähigen keramischen Barriereschichten.

Zudem bevorzugt ist ein erfindungsgemäßes Verfahren mit folgendem zusätzlichen Schritt: Entfernen der keramischen Barriereschicht auf vorzugsweise mechanischem Wege. Vorteilhaft ist eine solche Verfahrensgestaltung insbesondere bei Verwendung einer nicht ausreichend leitfähigen Barriereschicht. Besonders bevorzugt wird das Entfernen der Barriereschicht so ausgestaltet, dass das metallische bandförmige Substrat sich beim Entfernen der Barriereschicht nicht auf eine Temperatur von über 100°C erhitzt. Zudem sollen im Substrat Versetzungen vermieden werden, die sich bis zur HTS-Seite fortsetzen. Auf diese Weise lässt sich das Abtragen der Barriereschicht besonders wirtschaftlich gestalten und kann darüber hinaus so präzise gesteuert werden, dass der Abtrag auf ein Minimum beschränkt wird und das dadurch wieder freigelegte Metallsubstrat nur in geringem Maße schädigt. Insbesondere soll eine Schädigung der HTS-Schicht ausgeschlossen werden.

Dabei erfolgt das Entfernen der keramischen Barriereschicht vorzugsweise durch Abrasion mit einer Diamantsuspension oder durch Putzstrahlen.

Erfindungsgemäß kann auch vorgesehen sein, dass das Entfernen der keramischen Barriereschicht durch CMP (Chemical Mechanical Polishing, chemisch-mechanisches Polieren, auch als chemisch-mechanisches Planarisieren bezeichnet) erfolgt, wobei beispielsweise Al₂O₃ in Wasser eingesetzt wird.

Schließlich betrifft die Erfindung noch einen bandförmigen HTS, der erhältlich ist mit dem erfindungsgemäßen Verfahren.

Die erfindungsgemäß vorgesehene keramische Barriereschicht muss im Gegensatz zu der (den) Schicht(en) auf der ersten Bandseite des Metallsubstrates nicht orientiert sein, da sie keine Textur zu übertragen braucht. Allerdings soll die Barriereschicht ausreichend dicht sein, um das Metall weitgehend vor einem oxidativen Angriff während der HTS-Kristallisationsglühung zu schützen, der die mechanische Festigkeit sowie die elektrische und thermische Leitfähigkeit des Metallsubstrats verändern kann.

In einem erfindungsgemäßen Vorprodukt können auch mehrere aneinander angrenzende Barriereschichten vorgesehen sein, wobei zur Herstellung eines solchen Vorprodukts beispielsweise
- zunächst auf der zweiten Bandseite eine den Sauerstoffzutritt zur ersten Bandseite verzögernde oder verhindernde erste Barriereschicht aus leitfähigem oder nicht-leitfähigem keramischem Material (wobei das keramische Material vorzugsweise ein Metalloxid oder eine Mischung von Metalloxiden ist) aufgebracht wird oder eine Beschichtung aufgebracht wird, die sich während der HTS-Kristallisationsglühung oder der Pyrolyse in eine solche erste Barriereschicht umwandelt
   und danach
- auf dieser ersten Barriereschicht eine (vorzugsweise leicht-ablösbare und/oder nicht-leitfähige) zweite Barriereschicht. Besteht eine der beiden Teilschichten aus nicht ausreichend leitfähigem Material, so muss in der Regel mindestens diese nach der HTS-Glühung wieder entfernt werden.

Die keramische Barriereschicht kann aus einem der Materialien bestehen, die für eine ggf. vorhandene Pufferschicht oder die HTS-Schicht auf der Oberseite des Metallsubstrates verwendet wird (wobei sie allerdings eine andere chemische Zusammensetzung und/oder eine andere Textur besitzt als die auf der ersten Seite angeordnete Schicht, welche unmittelbar an dem Substrat anliegt), aber auch aus einem davon verschiedenen Material. Wie bereits erwähnt, ist die keramische Barriereschicht dabei vorzugsweise eine den Sauerstoffzutritt zur zweiten Bandseite verzögernde oder verhindernde Schicht aus leitfähigem oder nicht-leitfähigem Metalloxid oder wandelt sich während der HTS-Kristallisationsglühung in eine solche um. Wenn die Barriereschicht aus einem hinreichend sauerstoffundurchlässigen Metall besteht, ist dies bevorzugt edler als die Bestandteile der für das Metallsubstrat verwendeten Legierung oder bildet leicht eine abdichtende Oxidhaut.

Die Barriereschicht muss nicht notwendigerweise ihre letztendliche Modifikation oder Stöchiometrie bereits vor einer üblicherweise erfolgenden HTS-Kristallisationsglühung des erfindungsgemäßen Vorproduktes angenommen haben. Es kann in Einzelfällen durchaus akzeptabel oder gewünscht sein, dass eine weitere Oxidation oder Kristallisation während der thermischen Behandlung des erfindungsgemäßen HTS-Vorprodukts abläuft.

Bei Verwendung eines leitfähigen Materials für die Barriereschicht kann daraus ein Zusatznutzen bei der elektrischen Ankopplung des bandförmigen HTS an einen später anzubringenden Metallshunt gezogen werden. Dies ist insbesondere dann von Vorteil, wenn auf der ersten Bandseite (HTS-Seite) mindestens ein nicht-leitfähiges Oxid als Pufferschicht zwischen Metallsubstrat und HTS-Schicht eingesetzt wird.

Eine Spezialfall besteht in der Verwendung leitfähiger Oxide als Barriereschichtmaterial, wie beispielsweise mit Fremdmetall dotierter Metalloxide, z. B. mit Aluminium dotierten Zinkoxids oder mit Zinn dotierten Indiumoxids, wobei ein Dotierungsgrad von mindestens 1 %, bevorzugter mindestens 5 % vorgesehen sein kann. Durch die Dotierung wird die Leitfähigkeit der Materialien auf bspw. 10⁻⁴ bis 10⁻⁵ Ohm/cm erhöht. Eine andere Alternative wäre die Verwendung einer Metalloxidschicht, die von sich aus bereits eine metallische Leitfähigkeit bietet, wie beispielsweise eine Lanthan-Nickel-Oxid-Schicht.

Die erfindungsgemäß einzusetzenden keramischen (oxidischen) Barriereschichten weisen vorzugsweise Leitfähigkeiten von > 10⁻⁸ Scm⁻¹ auf, vorzugsweise von > 10⁻⁶ Scm⁻¹.

Alternativ zur Verwendung einer leitfähigen Schicht kann die zweite Bandseite (Rückseite) des Metallsubstrates vor der HTS-Kristallisationsglühung mit einer beliebigen oxidischen und nicht-leitfähigen Barriereschicht versehen werden. Die für die spätere weitere Verwendung notwendige Wiederherstellung der elektrisch leitfähigen Fläche auf der ersten Bandseite des Metallsubstrats erfolgt dann vorzugsweise durch eine mechanische Entfernung der keramischen Barriereschicht nach der HTS-Kristallisationsglühung und Sauerstoffbeladung.

Dies kann beispielsweise dadurch erreicht werden, dass die beschichtete zweite Bandseite des Metallsubstrats über einen rotierenden Filz gezogen wird, der mit einer Diamantsuspension getränkt ist. Verbleibende Diamantpartikel werden anschließend in einer Spülkaskade entfernt. Die Verwendung einer Diamantsuspension mit einer definierten mittleren Partikelgröße von z. B. 100 nm gewährleistet, dass lediglich oberflächlich Material abgetragen wird.

Alternativ kann das Abtragen der keramischen Barriereschicht durch Putzstrahlen erfolgen.

Es sollte dabei sorgfältig darauf geachtet werden, dass vorwiegend die Barriereschicht entfernt wird, und vermieden werden, dass das regelmäßig weichere Metallsubstrat bis in tiefere Bereiche beschädigt wird, wodurch sich Versetzungen bis zur gegenüberliegenden Trägersubstratoberfläche fortpflanzen könnten, wo sie zu einer Delamination der Pufferarchitektur führen könnten.

Eine bevorzugte Ausgestaltung zur Entfernung der Barriereschicht und der Wiederherstellung der metallischen Oberfläche des metallischen bandförmigen Substrats ist das chemisch-mechanische Polieren (Chemical Mechanical Polishing (CMP)), auch bekannt als chemisch-mechanisches Planarisieren.

Eine Barriereschicht in nicht-leitfähiger Ausführung kann beispielsweise aus einer extrem dünnen (beispielsweise 20 - 100 nm) Lanthanzirkonatschicht bestehen, die in üblicher Weise durch ein CSD (Chemical Solution Deposition)-Verfahren, z. B. eine Tauchbeschichtung oder Schlitzdüsenbeschichtung, auf die zweite Bandseite (Rückseite) des metallischen bandförmigen Substrats aufgebracht werden kann. Bei Verwendung nicht-leitfähiger Pufferschichten auf der ersten Bandseite (Vorderseite, HTS-Seite) wird es notwendig sein, eine solche nicht-leitfähige Barriereschicht im Anschluss an die HTS-Kristallisationsglühung wieder zu entfernen, um die Leitfähigkeit auf der Rückseite des Metallsubstrats wiederherzustellen.

Alternativ kann - wie bereits aus dem Stand der Technik bekannt - die fertige Supraleiter-Architektur oben und unten mit Metallfolien aus z. B. Kupfer oder Messing verlötet werden, die an den Seiten mit einem Lot geschlossen werden, das dann den elektrischen Kontakt herstellt. Auf diese Weise lassen sich Shuntlayers aus unterschiedlichen Metallen oder Legierungen und in beliebigen Dicken konstruieren.

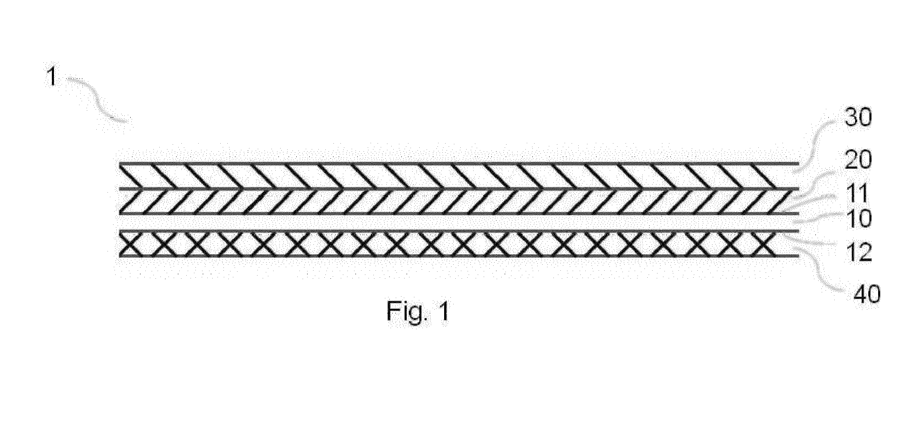

In der beigefügten einzigen Figur 1 ist beispielhaft ein erfindungsgemäßes Vorprodukt schematisch und nicht maßstabsgerecht dargestellt.

Das erfindungsgemäße Vorprodukt 1 weist ein metallisches bandförmiges Substrat 10 mit einer ersten Bandseite 11 und einer zweiten Bandseite 12 auf. Die erste Bandseite 11 dient der Aufnahme des für einen HTS üblichen Schichtaufbaus, im vorliegenden Beispiel einer einzelnen Pufferschicht 20 und darüber einer HTS-Schicht 30.

Die Rückseite (zweite Bandseite) 12 des metallischen Substrats 10 trägt die erfindungsgemäß vorgesehene keramische Barriereschicht 40 zum Schutz vor oxidativem Angriff.

## Patentansprüche

1. Vorprodukt (1) zur Herstellung eines bandförmigen Hochtemperatursupraleiters (HTS), umfassend
ein metallisches bandförmiges Substrat (10) mit einer ersten Bandseite (11) und einer zweiten Bandseite (12), wobei
auf der ersten Bandseite (11)
(a) das Substrat (10) eine vorgegebene Textur als Templat für ein kristallografisch ausgerichtetes Aufwachsen einer Pufferschicht oder einer HTS-Schicht besitzt
und
(b) eine freiliegende Oberfläche des Substrats (10) vorliegt oder eine oder mehrere Schichten (20,30) vorliegen, die ausgewählt sind aus der Gruppe bestehend aus: Puffer-Precursor-Schicht, pyrolysierte Puffer-Precursor-Schicht, Pufferschicht, HTS-Precursor-Schicht, pyrolysierte HTS-Puffer-Precursor-Schicht und pyrolysierte und weiter verdichtete HTS-Puffer-Precursor-Schicht,
und
auf der zweiten Bandseite (12) mindestens eine das Substrat (10) gegen Oxidation schützende keramische Barriereschicht (40) oder eine Vorstufe, die sich während der HTS-Kristallisationsglühung oder der Pyrolyse in eine solche umwandelt, vorliegt,
wobei, wenn auf der ersten Bandseite (11) eine oder mehrere Schichten (20, 30) vorliegen, die keramische Barriereschicht (40) oder deren Vorstufe eine andere chemische Zusammensetzung besitzt und/oder eine andere Textur besitzt als die auf der ersten Bandseite (11) angeordnete Schicht (20), welche unmittelbar an dem Substrat (10) anliegt.

2. Vorprodukt nach Anspruch 1, **dadurch gekennzeichnet, dass** auf der ersten Bandseite (11)
eine einzelne Pufferschicht (20) vorliegt und die Pufferschicht (20) epitaktisch aufgewachsen ist
oder
mehrere epitaktisch aufgewachsene Pufferschichten vorliegen.

3. Vorprodukt nach einem der vorangehenden Ansprüche, **dadurch gekennzeichnet, dass** die Barriereschicht (40) eine den Sauerstoffzutritt zur zweiten Bandseite (12) verzögernde oder verhindernde Schicht aus leitfähigem oder nicht-leitfähigem keramischem Material ist oder oder eine Vorstufe, die sich während der HTS-Kristallisationsglühung oder der Pyrolyse in eine solche umwandelt.

4. Vorprodukt nach Anspruch 3, **dadurch gekennzeichnet, dass** das keramische Material ein elektrisch leitfähiges Metalloxid oder eine elektrisch leitfähige Mischung von Metalloxiden ist, wobei das leitfähige Metalloxid bzw. ein oder mehrere Metalloxide der leitfähigen Mischung vorzugsweise ein mit einem Fremdmetall dotiertes Metalloxid sind.

5. Vorprodukt nach Anspruch 4, **dadurch gekennzeichnet, dass** das mit einem Fremdmetall dotierte Metalloxid ausgewählt ist aus der Gruppe bestehend aus dotiertem Zinkoxid, dotiertem Indiumoxid, mit Niob dotiertem Strontiumtitanat und Lanthannickelat.

6. Vorprodukt nach Anspruch 4 oder 5, **dadurch gekennzeichnet, dass** der Dotierungsgrad des mit einem Fremdmetall dotierten Metalloxids bei mindestens 1% liegt bezogen auf die Gesamtzahl der Metallionen in der Barriereschicht.

7. Vorprodukt nach Anspruch 3, **dadurch gekennzeichnet, dass** die Dicke der Schicht aus nicht-leitfähigem Metalloxid maximal 10% der Dicke des Substrats beträgt.

8. Vorprodukt nach einem der Ansprüche 3 oder 7, **dadurch gekennzeichnet, dass** das nicht-leitfähige Metalloxid ausgewählt ist aus der Gruppe bestehend aus Lanthanzirkonat, Yttriumoxid, Lanthanaluminat, Strontiumtitanat und Kalziumtitanat.

9. Verfahren zur Herstellung eines bandförmigen HTS, mit folgendem Schritt:
- Bereitstellen oder Herstellen eines Vorprodukts (1) nach einem der Ansprüche 1 bis 11,
wobei auf der ersten Bandseite (12) eine pyrolysierte HTS-Precursor-Schicht vorliegt,
- Kristallisationsglühen des Vorprodukts (1).

10. Verfahren nach Anspruch 9, **dadurch gekennzeichnet, dass** die keramische Barriereschicht (40) mit einem CSD(Chemical Solution Deposition)-Verfahren auf das metallische Substrat aufgebracht wird.

11. Verfahren nach Anspruch 10, **dadurch gekennzeichnet, dass** das CSD-Verfahren ausgewählt ist aus der Gruppe bestehend aus Tauchbeschichtung, Schlitzdüsenbeschichtung und Druckbeschichtung.

12. Verfahren nach einem der Ansprüche 9 bis 11, mit folgendem zusätzlichen Schritt:
Entfernen der keramischen Barriereschicht (40) auf vorzugsweise mechanischem Wege.

13. Verfahren nach Anspruch 12, **dadurch gekennzeichnet, dass** das Entfernen der keramischen Barriereschicht (40) durch Abrasion mit einer Diamantsuspension oder durch Putzstrahlen erfolgt.

14. Verfahren nach Anspruch 13, **dadurch gekennzeichnet, dass** das Entfernen der keramischen Barriereschicht (40) durch CMP (Chemical Mechanical Polishing) erfolgt.

15. Bandförmiger HTS, erhältlich mit einem Verfahren nach einem der Ansprüche 9 bis 14.
